# EUROPEAN PATENT APPLICATION

(11) **EP 1 115 140 A2**
(43) Date of publication of application: **11.07.2001**
(21) Application number: 00118405.0
(22) Date of filing: 24.08.2000
(51) Int. Cl.: H01J 37/32

(54) **Plasma processing apparatus**

(30) Priority: 06.01.2000 JP 2000000686
(71) Applicant: Hitachi, Ltd., Chiyoda-ku, Tokyo 101-8010 (JP)
(72) Inventor: Uchino, Takeo, Hitachi-shi, Ibaraki 316-0001 (JP); Setoyama, Eiji, Hitachi-shi, Ibaraki 316-0011 (JP); Ishiguro, Kouji, Hitachi-shi, Ibaraki 316-0001 (JP)
(74) Representative: Strehl Schübel-Hopf & Partner

(57) **Abstract**

The present invention provides a compact plasma processing apparatus for performing a plasma process on a substrate 100 having a large diameter without increasing the capacity of the high frequency power source. A substrate holder 120 for loading the substrate 100 and a substrate holder cover 150 for covering the outer periphery of the substrate holder 120 are arranged in a plasma processing chamber 20. When high frequency power is applied to the substrate holder 120, the plasma process is performed on the substrate 100. The substrate holder cover 150 has a structure of low dielectric constant.

## Description

### BACKGROUND OF THE INVENTION

### Field of the Invention

The present invention relates to a plasma processing apparatus and more particularly to a plasma processing apparatus suited to be used for a plasma etching apparatus, a plasma CVD film forming apparatus, a sputtering film forming apparatus, and others using the ion etching phenomenon using high frequency waves.

### Related Background Art

Conventionally, in a plasma processing apparatus for plasma-processing a substrate such as a wafer, at a negative self bias voltage generated by applying high frequency waves such as RF to the substrate holder for supporting the substrate, by allowing positive ions in plasma to enter into the substrate, a fine film is formed or an inter-layer insulating film of a high aspect ratio is formed. High frequency waves are applied to the electrode in the substrate holder or the substrate holder itself. When high frequency waves are to be applied to the whole substrate holder, to keep the insulation between the substrate holder and the chamber which is a ground potential, the substrate holder support plate has a structure of holding an insulator such as Teflon. When high frequency waves are to be applied to the substrate electrode in the substrate holder, the substrate holder support plate has a structure that a high frequency introduction rod is inserted in the substrate holder and an insulating cylinder of Teflon or others is inserted around it.

Recently, in a plasma processing apparatus, the substrate size to be processed has been made larger. For example, the conventional wafer size is 8 inches, while processing of a wafer of a size of 12 inches is being planned. When the substrate size is increased like this, it is found that the following problem will arise. Next, a case that a bias plasma CVD device for forming an inter-layer insulating film between wires is used as a plasma processing apparatus will be explained hereunder.

Generally, when embedding film forming between wires is to be carried out, the high frequency power is applied to the substrate holder under the substrate and a self bias potential is generated in the substrate. By doing this, positive ions of plasma can be given the directivity and can be entered the substrate with great energy within the range from several tens V to several hundreds V or so.

As a result, the sputtering efficiency is improved and film forming and etching can be carried out at the same time, so that an inter-layer insulating film of a high aspect ratio can be obtained at high speed.

For plasma processing of a substrate with a large diameter, power density more than a certain value per unit area is necessary, so that more high frequency power is necessary. For film forming by embedding a groove with a high aspect ratio, it is necessary to increase the high frequency power and increase the number of ions and energy for colliding with a substrate. In either case, an increase in the high frequency power is required. To solve this problem, it is considered to increase the capacity of the high frequency power source. However, in correspondence with enlargement of a substrate, the plasma processing apparatus itself is enlarged, so that a first problem arises that in relation to the installation space, a large high frequency power source cannot be used.

To cover the substrate holder, a substrate holder cover is used. However, the substrate holder cover is exposed to plasma, so that sputtering due to collision of ions is generated and a second problem of contamination of a substrate by the substrate holder cover arises.

### SUMMARY OF THE INVENTION

An object of the present invention is to provide a compact plasma processing apparatus for performing the plasma process of a substrate with a large diameter without increasing the capacity of the high frequency power source.

Another object of the present invention is to provide a plasma processing apparatus for reducing contamination.
(1) To accomplish the above first object, in a plasma processing apparatus of the present invention including a substrate holder which is arranged inside a plasma processing chamber and holds a substrate on it and a substrate holder cover for covering the outer periphery of the substrate holder, applying high frequency power to the substrate holder, and performing the plasma process of the substrate, the substrate holder cover has a low dielectric constant structure composed of one or a plurality of members.
   By use of such a constitution, the electrostatic capacity of the substrate holder cover is made smaller, and the utilization factor of high frequency power for a substrate is improved, and the capacity of the high frequency power source is kept small, and the plasma process of a substrate with a large diameter can be performed compactly.
(2) In (1) mentioned above, a hollow is preferably formed inside the substrate holder cover.
(3) In (1) mentioned above, a honeycomb structure is preferably formed inside the substrate holder cover.
(4) In (1) mentioned above, preferably a hollow is formed inside the substrate holder cover and the hollow is filled with a low dielectric material.
(5) In (1) mentioned above, preferably the substrate holder cover is formed by a low dielectric constant material and a coating film is formed on the surface onto which plasma is irradiated.
(6) To accomplish the above first object, in a plasma processing apparatus of the present invention including a substrate holder which is arranged inside a plasma processing chamber and holds a substrate on it and a substrate holder cover for covering the outer periphery of the substrate holder, applying high frequency power to the substrate holder, and performing the plasma process of the substrate, the electrostatic capacity C4 between the substrate holder cover around the substrate and the facing plasma is made smaller than the electrostatic capacity C2 of the substrate holder opposite to plasma via the substrate.
   By use of such a constitution, the electrostatic capacity of the substrate holder cover is made smaller, and the utilization factor of high frequency power for a substrate is improved, and the capacity of the high frequency power source is kept small, and the plasma process of a substrate with a large diameter can be performed compactly.
(7) To accomplish the above second object, in a plasma processing apparatus of the present invention including a substrate holder which is arranged inside a plasma processing chamber and holds a substrate on it and a substrate holder cover for covering the outer periphery of the substrate holder, applying high frequency power to the substrate holder, and performing the plasma process of the substrate, a curved portion is formed at the end of the periphery of the substrate holder cover.
   By use of such a constitution, the surface area of the substrate holder cover is made smaller and contamination from the substrate holder cover is reduced.
(8) To accomplish the above second object, in a plasma processing apparatus of the present invention including a substrate holder which is arranged inside a plasma processing chamber and holds a substrate on it and a substrate holder cover for covering the outer periphery of the substrate holder, applying high frequency power to the substrate holder, and performing the plasma process of the substrate, the ratio CA/CB of the combined electrostatic capacity CA of the electrostatic capacity C1 of the substrate and the electrostatic capacity C2 of the substrate holder to the combined electrostatic capacity CB of the electrostatic capacity C1 of the substrate, the electrostatic capacity C2 of the substrate holder, the capacity to ground C3, and the electrostatic capacity C4 between the holder and plasma is set to 70% or more.

By use of such a constitution, the utilization factor of high frequency power for a substrate is improved, and the capacity of the high frequency power source is kept small, and the plasma process of a substrate with a large diameter can be performed compactly.

### BRIEF DESCRIPTION OF THE DRAWINGS

Fig. 1 is a cross sectional view showing the whole constitution of a plasma processing apparatus of an embodiment of the present invention.

Fig. 2 is an illustration showing the situation of transmission of high frequency power to plasma via a substrate in a plasma processing apparatus of an embodiment of the present invention.

Fig. 3 is an equivalent circuit of a transfer system of high frequency power in a plasma processing apparatus of an embodiment of the present invention.

Fig. 4 is a cross sectional view showing a first constitution example of a substrate holder cover used in a plasma processing apparatus of an embodiment of the present invention.

Fig. 5 is a cross sectional view showing a second constitution example of a substrate holder cover used in a plasma processing apparatus of an embodiment of the present invention.

Fig. 6 is a cross sectional view showing a third constitution example of a substrate holder cover used in a plasma processing apparatus of an embodiment of the present invention.

Fig. 7 is a cross sectional view showing a fourth constitution example of a substrate holder cover used in a plasma processing apparatus of an embodiment of the present invention.

### DETAILED DESCRIPTION OF PREFERRED EMBODIMENTS

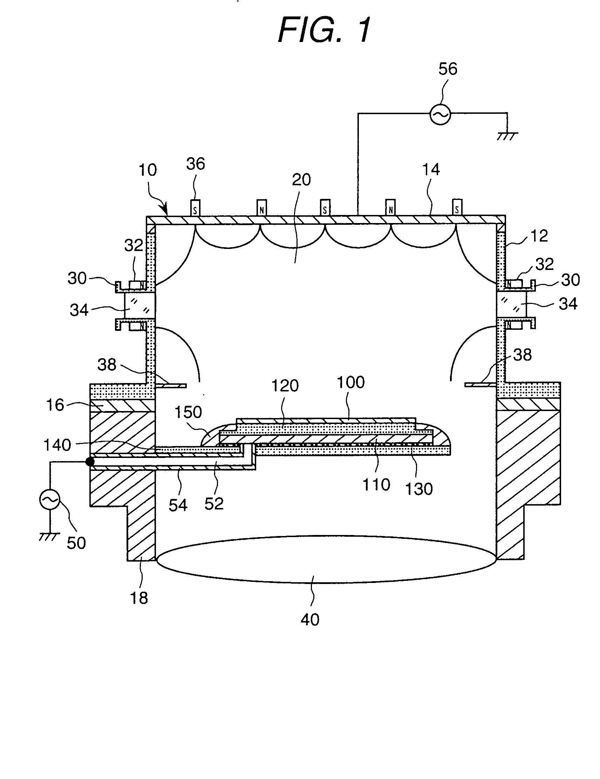

The constitution of a plasma processing apparatus of an embodiment of the present invention will be explained hereunder with reference to Figs. 1 to 7.

Firstly, by referring to Fig. 1, the whole constitution of the plasma processing apparatus of this embodiment will be explained.

Fig. 1 is a cross sectional view showing the whole constitution of a plasma processing apparatus of an embodiment of the present invention.

A plasma processing container 10 is composed of a cylindrical side wall 12, a ceiling 14, an insulator 16, and a base plate 18. Inside the plasma processing container 10, a plasma processing chamber 20 is formed. The plasma processing chamber 20 is installed on the base plate 18 via the insulator 16. The bottom of the base plate 18 is interconnected to an evacuation device 40, which evacuates the plasma processing chamber 20.

On the side wall 12, a wave guide 30 for microwave introduction is integratedly formed. Above and under the wave guide 30, permanent magnets 32 are arranged and form an electron cyclotron resonance magnetic field. In the wave guide 30, a quartz window 34 for sealing the vacuum is installed. On the side wall 12, a gas inlet 38 is installed. From the gas inlet 38, for example, SiH₄ gas or O₂ gas is introduced into the plasma processing chamber 20. On the top of the ceiling 14, magnets 36 are arranged.

Inside the plasma processing chamber 20, at the position opposite to the ceiling 14, a high frequency electrode 110 for supporting a substrate 100 such as a wafer is installed. The wave guide 30 is installed so that a microwave is introduced into the plasma processing chamber 20 almost in parallel with the surface of the substrate 100.

The substrate 100 is put on a substrate holder 120. The substrate holder 120 is held on the high frequency electrode 110. The high frequency electrode 110 is held on an insulator 130. A substrate holder support member 140 supports the whole substrate holder and is fixed to the base plate 18. The outer periphery of the substrate holder 120 and the high frequency electrode 110 are covered with a substrate holder cover 150. The high frequency electrode 110 may be built in the substrate holder 120. Although not shown in the drawing, the substrate 100 is transferred in and out from the plasma processing chamber 20 from another chamber by the transfer robot.

The high frequency power output from a high frequency power source 50 is applied to the high frequency electrode 110 via a high frequency introduction rod 52. The high frequency introduction bar 52 is insulated from the base plate 18 by an insulator 54. The high frequency power output from a high frequency power source 56 is applied to the ceiling 14.

Next, the operation of the plasma processing apparatus of this embodiment will be explained.

When a microwave enters into the plasma processing chamber 20 from the wave guide 30, by the electron cyclotron resonance magnetic field generated by the permanent magnets 32 arranged above and under the wave guide 30, electrons are generated and heated, and high-energy electrons are wound round the lines of magnetic force of the permanent magnets 36 and diffused inside the chamber, and plasma is generated by collision with the high-energy electrons. For example, when the frequency of a microwave is 2.45 GHz, the intensity of the electron cyclotron resonance magnetic field is 875 Gauss. During the film forming process, to the high frequency electrode 110, a high frequency power source for applying a high frequency voltage at a frequency of 13.56 MHz is connected.

By a chemical reaction of radical and O radical such as SiH₃ and SiH₂ generated when high-energy electrons are ionized and dissociated with gas in the plasma processing chamber, for example, SiH₄ and then dissociated, reaction film forming substances are accumulated on the substrate 100. In this case, the high frequency electrode 110 gives bias potential to the substrate surface, gives the directivity of plasma ions, also allows to form a fine film by a shock of ions onto the film forming surface, and performs an embedding film forming process of a high aspect ratio at high speed.

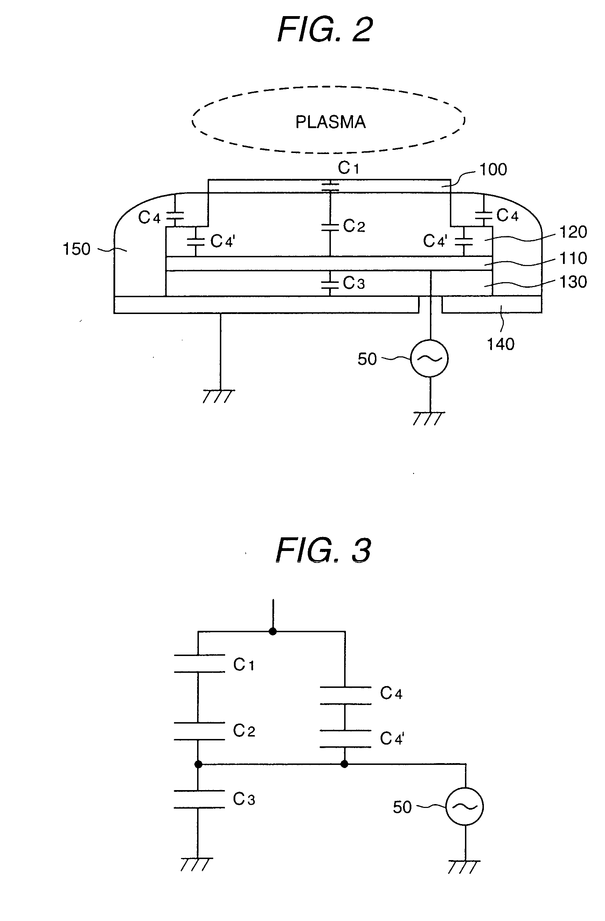

Next, by referring to Fig. 2, the situation of the high frequency power of the plasma processing apparatus in this embodiment to be transmitted to plasma via the substrate will be explained.

Fig. 2 is an illustration showing the situation of the high frequency power of the plasma processing apparatus in one embodiment of the present invention to be transmitted to plasma via the substrate.

There are three kinds of high frequency power added to the high frequency electrode 110 from the high frequency power source 50 available such as a one which is transmitted into plasma mainly via the substrate holder 120 and the substrate 100, a one which is transmitted into plasma via the substrate holder cover 150, and a one which is grounded by the substrate holder support member 140 via the insulator 130 under the high frequency electrode 110.

In this case, C1 indicates electrostatic capacity of a wafer which is the substrate 100 and it is a constant. C2 indicates electrostatic capacity of the substrate holder (electrostatic chuck) 120, and C3 indicates electrostatic capacity of the insulator 130 held by the high frequency electrode 110 and the substrate holder support member 140, and C4 indicates electrostatic capacity (mainly the substrate holder cover 150) between the high frequency electrode 110 and the portion other than the substrate which is in contact with plasma.

Next, by referring to Fig. 3, the electrically equivalent circuit shown in Fig. 2 will be explained.

Fig. 3 is an equivalent circuit diagram of a high frequency power transfer system of a plasma processing apparatus of an embodiment of the present invention.

For plasma processing of a substrate with a large diameter, power density more than a certain value per unit area is necessary, so that more high frequency power is necessary. In order to increase the high frequency power, in this embodiment, instead of increasing the capacity of the high frequency power source, the utilization factor of high frequency power to the substrate is improved.

The utilization factor of the high frequency power to be applied to the substrate is obtained by the radio of electrostatic capacity C^{*} composed of the electrostatic capacity C2 between the high frequency electrode 110 in the substrate holder and the substrate 100, the electrostatic capacity C3 of other than it, for example, between the substrate holder 120 and the insulator 130 for supporting the substrate holder, and the electrostatic capacity C4 between the high frequency electrode 110 and the substrate holder cover 150.

Generally, the electrostatic capacity C is obtained from C = ε×S/d (S: area, d: distance, ε: dielectric constant), so that it is in proportion to the dielectric constant and area and in inverse proportion to the distance. It is also obtained from the inductance of high frequency r = 1 / (jωC) (j: complex number, ω = 2πf: angular frequency).

Therefore, to improve the utilization factor of the high frequency power to be applied to the substrate 100, by sufficiently increasing the electrostatic capacity C2 between the high frequency electrode 110 in the substrate holder and the substrate 100 compared with that of other parts, the improvement can be realized. For that purpose, when the high frequency is fixed, it is desirable to make the electrostatic capacity of any portion in contact with other than the substrate smaller, use a material of a small dielectric constant, or form a shape of low electrostatic capacity. Particularly, in the electrostatic capacity of any portion in contact with other than the substrate, the rate held by the substrate holder cover 150 is large, so that the utilization factor of the high frequency power is adversely affected greatly. For example, in a structure that a wafer of a size of 8 inches is supported, when Teflon is used as an insulator, the electrostatic capacity C3 is about 0.1 nF, while the electrostatic capacity C4 of the substrate holder cover 150 made of alumina is about 0.6 nF. As the wafer size is enlarged, the electrostatic capacity of the substrate holder cover 150 is also enlarged.

Therefore, the electrostatic capacity C of the substrate holder cover 150 is reduced, and the impedance is increased, and effective use of the high frequency power to the substrate is intended. Improvement of the utilization factor of the high frequency power is a key point for high-speed embedding film forming of a fine groove of a high aspect ratio in a wafer with a large diameter, miniaturization of the apparatus, and realization of a low price.

As shown in the equivalent circuit in Fig. 3, when the electrostatic capacity C3 and the electrostatic capacity C4 are reduced and the impedance thereof is increased, the high frequency power can be applied to the substrate effectively. In this embodiment, the electrostatic capacity C4 of the substrate holder cover 150 is made smaller.

The ratio CA/CB of the combined electrostatic capacity CA of the electrostatic capacity C1 of the substrate and the electrostatic capacity C2 of the substrate holder to the combined electrostatic capacity CB of the electrostatic capacity C1 of the substrate, the electrostatic capacity C2 of the substrate holder, the capacity to ground C3, and the electrostatic C4 between the holder and plasma is set to 70% or more.

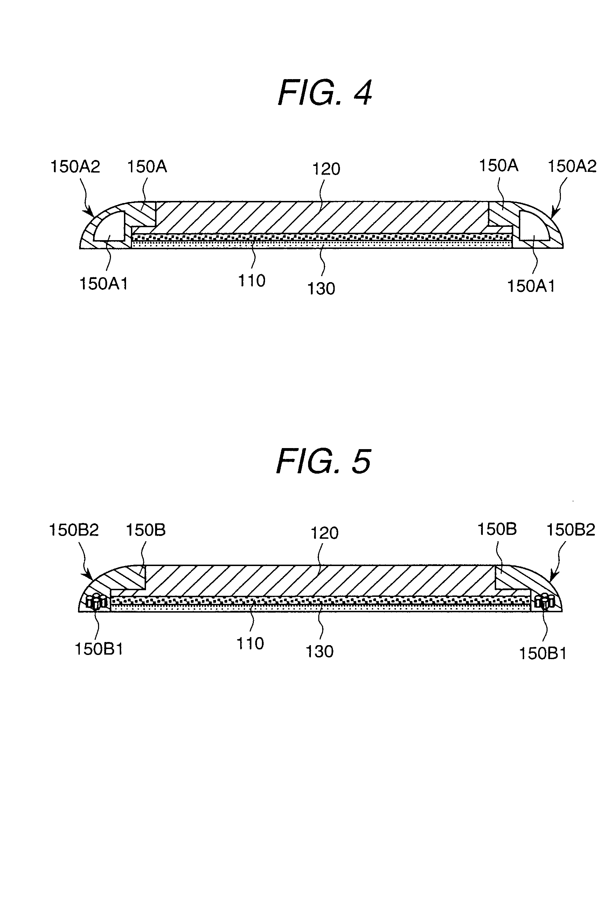

Next, by referring to Figs. 4 to 7, the constitution of the substrate holder cover used in the plasma processing apparatus of this embodiment will be explained. Each same numeral shown in Figs. 1 and 2 indicates the same part.

Firstly, by referring to Fig. 4, the first constitution example of the substrate holder cover used in the plasma processing apparatus of this embodiment will be explained.

Fig. 4 is a cross sectional view showing the first constitution example of a substrate holder cover used in a plasma processing apparatus of an embodiment of the present invention.

The substrate holder 120, as shown in Fig. 1, is circular so as to hold a circular substrate such as a wafer. The high frequency electrode 110 and the insulator 130 are also circular. The substrate holder cover 150A is in a shape of torus so as to cover the outer periphery of the substrate holder 120 and the high frequency electrode 110.

In this embodiment, the substrate holder cover 150A is made of alumina ceramics and has a hollow 150A1 formed inside, so that it has a low dielectric constant structure. The dielectric constant ε of alumina ceramics is large such as 9 to 10, while the dielectric constant of a vacuum is 1, so that when the same size as that of a conventional one is used, the electrostatic capacity can be reduced to about 1/3.

According to this embodiment, on the outer peripheral surface of the substrate holder cover 150A, a curved portion 150A2 is formed. The curved portion 150A2, as shown in the sectional shape in Fig. 4, is in an R shape. A conventional substrate holder cover has a rectangular section, while the substrate holder cover 150A is in a shape having a curved portion, so that sputtering is generated due to a shock by ions and the rate of contamination directly entering the substrate from the substrate holder cover 150A can be reduced.

Next, by referring to Fig. 5, the second constitution example of the substrate holder cover used in the plasma processing apparatus of this embodiment will be explained.

Fig. 5 is a cross sectional view showing the second constitution example of a substrate holder cover used in a plasma processing apparatus of an embodiment of the present invention.

The substrate holder cover 150B is made of alumina ceramics and has a honeycomb shape 150B1 inside. Since the honeycomb shape 150B1 is formed, voids are provided in the substrate holder cover 150B, and a low dielectric constant structure is formed, and the electrostatic capacity is reduced, and also the strength can be increased. By use of the honeycomb structure, when the same size as that of a conventional one is used, the electrostatic capacity can be reduced to about 1/2.

According to this embodiment, since a curved portion 150B2 is formed on the outer peripheral surface of the substrate holder cover 150B, contamination from the substrate holder cover 150B to the substrate is reduced.

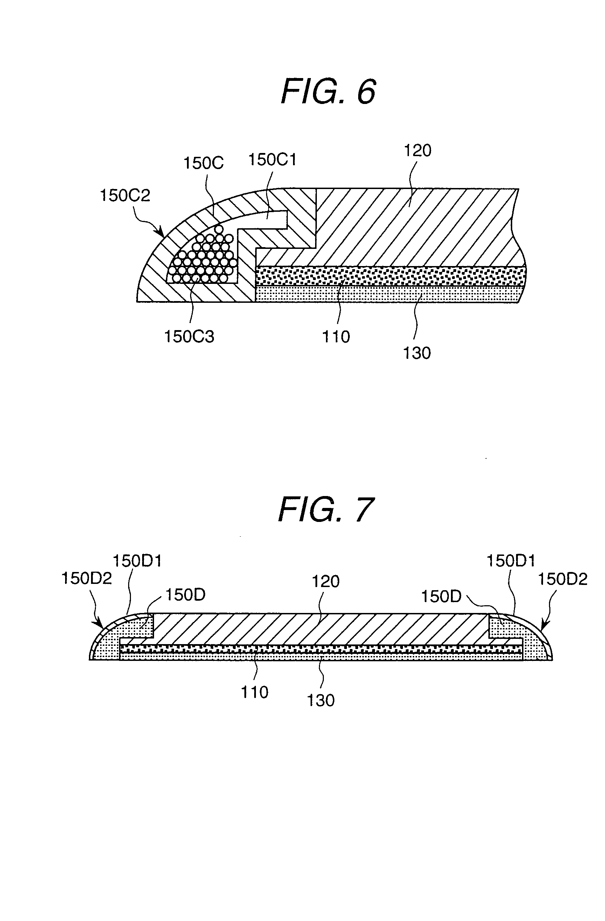

Next, by referring to Fig. 6, the third constitution example of the substrate holder cover used in the plasma processing apparatus of this embodiment will be explained.

Fig. 6 is a cross sectional view showing the third constitution example of a substrate holder cover used in a plasma processing apparatus of an embodiment of the present invention.

The substrate holder cover 150C is made of alumina ceramics and a void 150C1 is provided in it. When the void 150C1 is chargedwith, for example, a lowdielectric constant material 150C3 like glass beads, a low dielectric constant structure is formed. When the void 150C1 is provided and the low dielectric constant material 150C3 is charged, a void is provided in the substrate holder cover 150C and the electrostatic capacity is reduced.

According to this embodiment, since a curved portion 150C2 is formed on the outer peripheral surface of the substrate holder cover 150C, contamination from the substrate holder cover 150C to the substrate is reduced.

Instead of the constitution that the void 150C1 in the substrate holder cover 150C is charged with the low dielectric constant material 150C3, the following constitution may be used.

The first constitution is that the substrate holder cover 150C itself is formed by a material including holes.

The second constitution is that the substrate holder cover 150C itself is formed so as to include holes, for example, by alumina.

The second constitution is that the substrate holder cover 150C is formed by this material and the surface member thereof and also formed by a material of a low dielectric constant or a member including holes as a surface member.

Next, by referring to Fig. 7, the fourth constitution example of the substrate holder cover used in the plasma processing apparatus of this embodiment will be explained.

Fig. 7 is a cross sectional view showing the fourth constitution example of a substrate holder cover used in a plasma processing apparatus of an embodiment of the present invention.

The substrate holder cover 150D is made of quartz and has a coating film 150D1 on its surface, so that it has a low dielectric constant structure. The dielectric constant ε of alumina ceramics is large such as 9 to 10, while the dielectric constant of quartz is 3.6, so that when the same size as that of a conventional one is used, the electrostatic capacity can be reduced to about 1/2. Single quartz has a low plasma resistance, so that on the surface of the substrate holder cover 150D, the coating film 150D1 is formed. The coating film 150D1, for example, is formed by a sapphire coat. The coat film thickness, for example, 1 to 2 µm.

According to this embodiment, since a curved portion 150D2 is formed on the outer peripheral surface of the substrate holder cover 150D, contamination from the substrate holder cover 150D to the substrate is reduced.

In the structures shown in Figs. 4 and 6, when the material of the substrate holder cover is quartz, as shown in Fig. 7, by forming a coating film on the surface of the substrate holder cover made of quartz, the substrate holder cover can be structured so as to have a low dielectric constant structure and also the plasma resistance can be improved.

As explained above, according to this embodiment, when the substrate holder cover is structured so as to have a low dielectric constant structure, the electrostatic capacity of the substrate holder cover is made smaller and the utilization factor of the high frequency power into the substrate can be improved. By doing this, embedding film forming of a high aspect ratio can be realized at high speed.

When a power source of the same capacity is used, an embedding film forming process of a high aspect ratio can be performed at higher speed and by improvement of the etching speed, a high-speed etching process and a high-speed sputtering process can be performed.

By improvement of the utilization factor of the high frequency power, the high frequency power source can be made compact, and the apparatus also can be downsized, and the cost can be decreased.

The plasma processing apparatus according to this embodiment can be also applied to a plasma processing apparatus using a high frequency power source such as a plasma etching apparatus and a sputtering film forming apparatus.

According to the present invention, without increasing the capacity of the high frequency power source, a compact plasma process of a substrate with a large diameter can be performed.

## Claims

1. A plasma processing apparatus including a substrate holder (120) arranged inside a plasma processing chamber (20) for holding a substrate (100), a substrate holder cover (150) for covering the outer periphery of said substrate holder (120), and means (110) for applying high frequency power to said substrate holder (120) and performing a plasma process on said substrate (100),
wherein said substrate holder cover (150) has a low dielectric constant structure composed of one or a plurality of members.

2. The apparatus of claim 1, wherein a hollow (150A1) is formed inside said substrate holder cover (150A).

3. The apparatus of claim 2, wherein said hollow (150C1) is filled with low dielectric material (150C3).

4. The apparatus of claim 1, wherein a honeycomb structure (150B1) is formed inside said substrate holder cover (150B).

5. The apparatus of claim 1, wherein said substrate holder cover (150D) is formed by low dielectric constant material and a coating film (150D1) is formed on the surface onto which plasma is irradiated.

6. A plasma processing apparatus including a substrate holder (120) arranged inside a plasma processing chamber (20) for holding a substrate (100), a substrate holder cover (150) for covering the outer periphery of said substrate holder (120), and means (110) for applying high frequency power to said substrate holder (120) and performing a plasma process on said substrate (100),
wherein the electrostatic capacity C4 between said substrate holder cover (150) around said substrate (100) and facing the plasma is smaller than the electrostatic capacity C2 of said substrate holder (120) opposite to plasma via said substrate (100).

7. A plasma processing apparatus including a substrate holder (120) arranged inside a plasma processing chamber (20) for holding a substrate (100), a substrate holder cover (150) for covering the outer periphery of said substrate holder (120), and means (110) for applying high frequency power to said substrate holder (120) and performing a plasma process on said substrate (100),
wherein a curved portion is formed at an end of the periphery of said substrate holder cover (150).

8. A plasma processing apparatus including a substrate holder (120) arranged inside a plasma processing chamber (20 for holding a substrate (100), a substrate holder cover (150) for covering the outer periphery of said substrate holder (120), and means (110) for applying high frequency power to said substrate holder (120) and performing a plasma process of said substrate (100),
wherein the ratio CA/CB of the combined electrostatic capacity CA, formed by the electrostatic capacity C1 of said substrate (100) and the electrostatic capacity C2 of said substrate holder (120), to the combined electrostatic capacity CB formed by the electrostatic capacity C1 of said substrate (100), the electrostatic capacity C2 of said substrate holder (120), the capacity to ground C3, and the electrostatic capacity C4 between said holder (120) and plasma, is 70% or more.
